# EUROPÄISCHE PATENTSCHRIFT

(11) **EP 0 310 783 B1**
(45) Veröffentlichungstag und Bekanntmachung des Hinweises auf die Patenterteilung: **22.02.1995**
(21) Anmeldenummer: 88112827.6
(22) Anmeldetag: 06.08.1988
(51) Int. Cl.: H03C 3/09, H03L 7/18

(54) **Verfahren zur Stabilisierung der Ausgangsfrequenz eines spannungsgesteuerten Oszillators sowie Oszillator- und Sensoreinrichtung, die nach dem Verfahren arbeitet**
Stabilisation method of the output frequency of a voltage-controlled oscillator, and oscillator and sensor device functioning in accordance with this method
Procédé de stabilisation de la fréquence de sortie d'un oscillateur commandé en tension ainsi que dispositif oscillateur et capteur qui fonctionne selon ce procédé

(30) Priorität: 07.08.1987 DE 3726224
(43) Veröffentlichungstag der Anmeldung: 12.04.1989
(73) Patentinhaber: Peter Lancier Maschinenbau-Hafenhütte GmbH & Co. KG, 48167 Münster (DE)
(72) Erfinder: Vemmer, Helmut, Dipl.- Ing.,, D-5600 Wuppertal 11 (DE)
(74) Vertreter: Hoffmeister, Helmut, Dr. Dipl.-Phys.

(56) Entgegenhaltungen:
- US-A- 4 387 351
- IEEE TRANS. ON CONSUMER ELECTRONICS, Band CE-25, Nr. 4, August 1979, Seiten649-668, IEEE; C.W. MALINOWSKI et al.: "A novel frequency-processing method andits implications on future tuning systems"

## Beschreibung

Die Erfindung geht aus von einem Verfahren zum Stabilisieren der Ausgangsfrequenz fᵥ eines spannungsgesteuerten Oszillators gemäß dem Oberbegriff des Anspruchs 1 und umfaßt außerdem eine spannungsgesteuerte Oszillatoreinrichtung (VCO) zur Durchführung des Verfahrens sowie eine Sensoreinrichtung.

Spannungsgesteuerte Osizillatoren (VCOs) sind Oszillatoren, bei denen die Ausgangsfrequenz mit der Eingangsspannung verändert werden kann. Ändert sich bei einem VCO die Ausgangsfrequenz linear mit der Eingangsspannung, so kann der VCO als U/F-Wandler eingesetzt werden. U/F-Wandler sind Einrichtungen zur Umwandlung von Gleichspannungen in zu diesen proportionale Frequenzen für Meß- oder Übertragungszwecke.

Aus der US-A-4 387 351 ist eine Schaltung zur Oszillatorstabilisierung bekannt. Dabei werden einem Integrator ein konstantes Referenzsignal, eine Pulsfolge als Regelspannung von einem Pulsgenerator und ein Frequenzabgleichsignal, das mit dem Ausgangssignal des Integrators auf eine Summenschaltung gegeben wird, eingegeben. Auf die Summenschaltung gelangt darüber hinaus ein von einem Hochpaßfilter beeinflußtes Modulationssignal. Das am Ausgang der Summenschaltung anstehende Signal gelangt zum VCO als Frequenzmodulator. Das Modulationssignal bewirkt nur eine symmetrische Frequenzänderung um eine konstante VCO-Mittenfrequenz herum. Der Modulationseingang kann demnach aus zwei Gründen nicht als statischer Spannungseingang eines U/F-Wandlers im Sinne eines allgemein gültigen linearen U/F-Wandlers betrachtet werden:
1. Die VCO-Frequenzänderung aufgrund der Modulationsspannung ergibt keine garantierte lineare Frequenzänderung, die alternativ auch als präziser U/F-Wandler fungieren könnte. Die Linearität ist nur so gut, wie die Linearität des verwendeten VCO's. In der Regel als Modulator für sehr kleine Frequenzänderungen ausreichend, jedoch nicht als U/F-Meßwandler für größere Frequenzänderungen geeignet.
2. Der Modulationseingang kann nur eine sehr kurzzeitige dynamische Frequenzänderung bewirken. Würde man eine statische Gleichspannung anlegen, wie dies bei einem U/F-Meßwandler auch möglich ist, so würde aufgrund des Regelkreises die Frequenzänderung mit der Geschwindigkeit der Regelzeitkonstanten wieder auf den Ausgangswert zurückgeregelt.
   D.h. die Frequenzänderung des VCO's beim Anlegen einer statischen Meßspannung ist dauerhaft gleich null.

Es sind weiterhin präzise, spannungsgesteuerte Oszillatoren bekannt - vgl. z. B. ELEKTOR, 1977, 5-51 -, die beispielsweise nach vorgenannter Literaturangabe nur einen Linearitätsfehler von 0,5 % und eine Temperaturdrift von 0,01 %/°C aufweisen. Mit Hilfe eines integrierten Schaltkreises RCA-CA 3130, der als Multivibrator arbeitet und rechteckförmige Impulse erzeugt, ergibt sich eine Folge von Rechteck-Impulsen als Ausgangssignal. Über ein Integrierglied wird die Ausgangsspannung des Multivibrators einem nichtinvertierenden Eingang eines zweiten integrierten Schaltkreises zugeführt, der als Komparator arbeitet. Der Ausgang des Komparators ist wiederum mit dem invertierenden Eingang des Multivibrators verbunden. Durch die Rückkopplung stellt sich die Spannung präzise ein. Oszillatoren der vorgenannten Art können durch aufwendige Schaltmaßnahmen genauer stabilisiert werden. Allerdings erfordern diese Schaltmaßnahmen weitere Komponenten, die den relativ hohen Stromverbrauch vorgenannter Oszillatoren weiter wesentlich erhöhen. Insbesondere für die Überwachung von Fernmeldekabeln mit abgelegenen Meßpunkten sind daher die bekannten Schaltungen weniger geeignet.

Es stellt sich demnach die Aufgabe, ein Verfahren zur Stabilisierung der Ausgangsfrequenz fᵥ eines spannungsgesteuerten Oszillators (VCO) anzugeben, der mit einem sehr präzisen Spannungs-Frequenz-Wandler zu realisieren ist. Die Aufgabe ist weiterhin, eine entsprechend angelegte Oszillator-Schaltung anzugeben.

Diese Aufgabe wird gelöst mittels eines Verfahrens zum Stabilisieren der Ausgangsfrequenz bei spannungsgesteuerten Oszillatoren (VCO), das mit den im Kennzeichen des Anspruches 1 aufgeführten Schritten arbeitet, sowie durch eine Oszillatoreinrichtung mit den im Anspruch 7 angegebenen Merkmalen. Vorteilhafterweise werden bei einer Sensoreinrichtung die in den Ansprüchen 7 und 8 angegebenen Merkmale eingesetzt. Die Erfindung umfaßt demnach einen präzisen U/F-Wandler, der mit einem quarzgesteuerten Flächenintegral der Regelspannung realisiert wird. Bei der Ausführung der Schaltung zeigt sich, daß diese stromsparend im Mikroampere-Bereich arbeitet und in CMOS-Technik ausführbar ist.

Es sei hervorgehoben, daß bei dem vorstehenden Verfahren nicht die Phasenwinkel zweier Frequenzen verglichen werden, wie dies bei einer Phase-Lock-Schaltung (PLL) geschieht. Bei einer PLL-Schaltung (vgl. beispielsweise Artikel von J. F. ROULSTON "Applying the Phase-locked Loop in Communications and Instrumentation"; The Radio and Electronic Engineer, Vol. 41, No 7, July 1971) arbeitet der Phase-Lock-Kreis als Proportionalregler in Bezug auf die Phase. Es gilt die Regelkreis-Bedingung, daß die Phasenabweichung$\text{(Θ₁ - Θ₀)}$
proportional dem Reziprokwert der Verstärkung ist, die vom Regelkreis ausgelöst wird.

Im vorliegenden Falle wird eine Gleichspannung Uᵥ mit einer Gleichspannung Uᵣ verglichen, wobei die Gleichspannung Uᵥ das Sensorsignal und die Gleichspannung Uᵣ eine Regelspannung ist, die sich proportional zur Ausgangsfrequenz des U/F-Wandlers verhält. Dies resultiert daraus, daß Uᵣ aus dem Flächenintegral einer Pulsfolge gebildet wird, wobei die Pulslänge tᵣ eine Konstante, quarzgesteuerte Zeit ist. Die Frequenz der Pulsfolge steht in fester Beziehung zur Frequenz des U/F-Wandlers. Die Linearität des U/F-Wandlers ist somit nur von der Stabilität des Quarz-Steuersignals abhängig. Außerdem bringt der Weg über den beschriebenen Spannungs-Frequenz-Wandler den Vorteil, daß eine vorhandene Quarz-Taktfrequenz einer Zeitmultiplexsteuerung des Sensors für die Regelung nutzbar ist. Auch diese Möglichkeit der Stabilisierung bietet eine PLL nicht. Eine PLL kann sich nur nach der Phasenlage des Eingangssignals richten und das Eingangssignal ist in diesem Fall eine reine Gleichspannung.

Ein spannungsgesteuerter Oszillator der vorbeschriebenen Art wird insbesondere in einen adressierbaren Sensor-Transmitter eingebaut. Hierbei handelt es sich um sogenannte intelligente Sensoren, die physikalische Meßgrößen abfühlen, wie Umgebungsdruck, Temperatur, Luftfeuchte und dergleichen, und elektrische Signale erzeugen, die dem gemessenen Wert der physikalischen Meßgröße entsprechen. Die elektrischen Signale, d. h. bestimmte Spannungen, werden mit Hilfe eines spannungsgesteuerten Oszillators in frequenzmodulierte elektrische Signale umgewandelt. Diese Signale können dann über Drahtleitungen ohne Zwischenverstärkung bis zu 200 km weit übertragen werden. Hierzu steht im allgemeinen, z. B. bei Kabelüberwachungsvorrichtungen, nur eine Kupfer-Doppelader zur Verfügung. Die Sensoren müssen daher parallel angeschlossen sein. Zur Abfrage und Ansteuerung des Meßkreises wird ein zeitsequentielles Multiplex-Verfahren angewendet, wobei im allgemeinen bis zu 127 Sensoren angeschlossen sein können.

Über die Kupfer-Doppelader erfolgt sowohl die Energieversorgung aller Sensoren als auch die zeitsequentielle Signalübertragung von jedem einzelnen Sensor. Damit die Sensoren der Adressierung entsprechend geordnet, nacheinander senden, ist eine Synchronisierung der Sensoren zueinander erforderlich. Die Synchronisation erfolgt im Moment des Aufschaltens der Betriebsspannung auf die Leitung. Jede Überwachungseinheit besitzt daher im allgemeinen einen quarzgesteuerten Taktgeber mit einer Frequenz von 32,728 kHz als Takt-Normal. Das bedeutet andererseits, daß das Takt-Normal auch für andere Zwecke zur Verfügung steht, bei denen eine Referenzfrequenz fᵣ benötigt wird. Besonders vorteilhaft ist daher die Anwendung des vorgenannten Verfahrens bei Sensor-Einrichtungen, die über ein derartiges quarzgesteuertes Frequenz-Normal verfügen.

Die Ausgangsfrequenz fᵥ des spannungsgesteuerten Oszillators ist so eingestellt, daß sie im allgemeinen zwischen 11 und 34 kHz liegt, wobei fᵥ die unmittelbar am Ausgang des Oszillators abgegebene Frequenz ist. Am Ausgang der Sensor- oder Oszillatoreinrichtung als Ganzes liegt im allgemeinen eine niedrigere Frequenz fₑ vor, z. B. 1/16 von fᵥ, da diese für die genannten Meßzwecke wesentlich günstiger zu verarbeiten ist.

In einfacher Weise läßt sich die erzeugte Regelspannung Uᵣ und die Eingangsspannung Uᵥ zur Regelung des spannungsgesteuerten Oszillators verwenden, wenn diesem ein Integrator mit Differenzeingang vorgeschaltet wird, der mit der Differenz ΔU = Uᵥ - Uᵣ einen idealen Integrator je nach Vorzeichen der Steuerspannung aufwärts oder abwärts integriert, so daß die Ausgangsspannung U_{d} 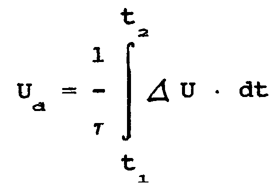
den Oszillator VCO steuert.

Dabei ist τ = eine schaltkreisabhängige Zeitkonstante; t₁ , t₂ sind sich praktisch ergebende Integrationsgrenzen entsprechend den Regeln der elektronischen Steuertechnik.

Eine Oszillatoreinrichtung, die nach dem Verfahren arbeitet, kann als präziser, spannungsgesteuerter Oszillator oder U/F-Wandler bezeichnet werden. Zur Stabilisierung der Ausgangsfrequenz fᵥ des U/F-Wandlers, an dessen Eingang die Spannung Uᵥ anliegt, ist ein Frequenznormal als Frequenzgeber mit der Referenzfrequenz fᵣ vorgesehen. Dessen Ausgangssignal wird einem Torschalter zusammen mit einem Signal B aufgegeben, dessen Frequenz ein festes Verhältnis 1/n zur Ausgangs-Frequenz fᵥ hat. Mit Hilfe des sequentiellen Schalters ist eine integrierbare Rechteck-Signalfolge C erzeugbar, bei der konstante Rechteckimpulse der Zeitlänge tᵣ = 1/fᵣ mit unterschiedliche Pausenzeiten tₚ zwischen den Rechteckimpulsen erzeugbar sind. Für den Zusammenhang von tᵣ , tₚ und fᵣ gilt, wie erwähnt:${\text{t}}_{\text{r}} {\text{+ t}}_{\text{p}} \text{=} \frac{\text{1}}{{\text{f}}_{\text{w}}}$
Zur Erläuterung der Erfindung ist eine Zeichnung beigefügt. Die Figuren der Zeichnung zeigen im einzelnen:
- Fig. 1: ein Blockschaltbild einer adressierbaren Sensor-Einrichtung, aus dem auch wesentliche Teile des spannungsgesteuerten Oszillators erkennbar sind;
- Fig. 2: synoptische Pulsdiagramme eines nach dem Verfahren arbeitenden spannungsgesteuerten Oszillators mit den zugehörigen Stabilisierschritten;
- Fig. 3: synoptische Pulsdiagramme des Oszillators mit der Wandlung des Rechteck-Ausgangssignals fₑ in ein Sinussignal mit der Frequenz fₒ.

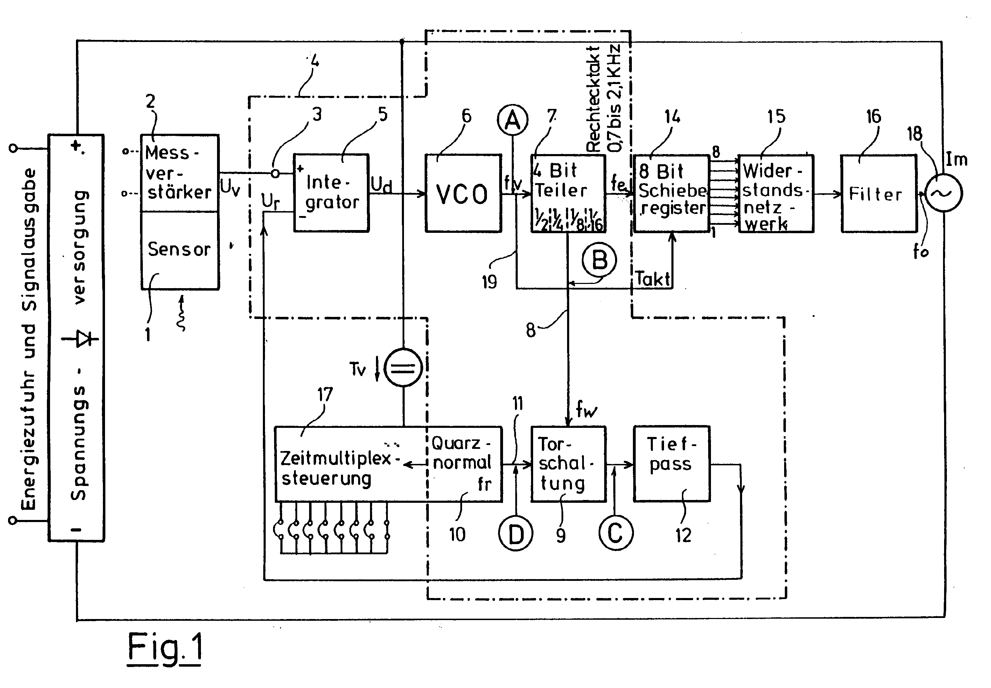

Figur 1 zeigt als schematisches Blockschaltbild eine adressierbare Sensor-Einrichtung, wie sie insbesondere bei der Drucküberwachung von Fernleitungen verwendet wird. Ein Sensor 1, der zur Drucküberwachung eingerichtet ist, erzeugt ein elektrisches Signal, das der betreffenden physikalischen Größe entspricht. Über einen Meßverstärker 2 wird das erhaltene Signal verstärkt und einem Eingang 3 einer U/F-Wandler-Einrichtung 4 mittels spannungsgesteuertem Oszillator (umrandet mit -.-) eingegeben. Die eingegebene Meßspannung wird mit Uᵥ bezeichnet. Die Spannung Uᵥ gelangt an den Plus(+)-Eingang eines Integrators 5, dem am Minus(-)-Eingang eine Regelspannung Uᵣ eingegeben wird, deren Erzeugung noch erläutert werden wird. Der Integrator 5 erzeugt ein Ausgangssignal nach der Formel

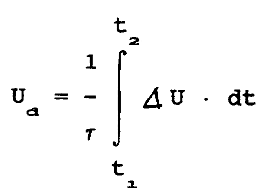

Der Ausgang des Integrators 5 ist über eine Leitung mit einem spannungsgesteuerten Oszillator (VCO) 6 verbunden. Der spannungsgesteuerte Oszillator 6 erzeugt in Abhängigkeit von der Eingangsspannung U_{d} ein Ausgangssignal "A" mit der Ausgangsfrequenz fᵥ in Form von Rechteck-Impulsen.

Die Frequenz fᵥ liegt bei dem vorliegenden Ausführungsbeispiel üblicherweise im Bereich zwischen 11,2 bis 33,6 kHz.

Es zeigt sich, daß die Ausgangsfrequenz fᵥ bei einem nicht-stabilisierten spannungsgesteuerten Oszillator 6 in der Regel nicht proportional zur Meß-Spannung Uᵥ ist. Es ist daher eine Regelung erforderlich. Dazu ist dem spannungsgesteuerten Oszillator 6 ein 4-Bit-Teiler 7 nachgeschaltet, dessen Ausgängen veschiedene, frequenzgeteilte Frequenzen entnehmbar sind.

Über eine Leitung 8 steuert ein Signal B der Frequenz fᵥ/4 einen sequentiellen Schalter oder Torschalter 9. Der Schalter 9 empfängt weiterhin ein konstant-frequentes Referenzsignal D der Frequenz fᵣ über eine Leitung 11, die von einem quarzgesteuerten Frequenz-Normal 10 abgegeben wird. Die vom Torschalter 9 erzeugten Rechteck-Signalimpulse ergeben eine Signalfolge "C", die einem Tiefpaß 12 aufgegeben wird. Der Tiefpaß 12 erzeugt die bereits erwähnte Regelspannung Uᵣ, die dem Minus(-)-Eingang des Integrators 5 aufgegeben wird.

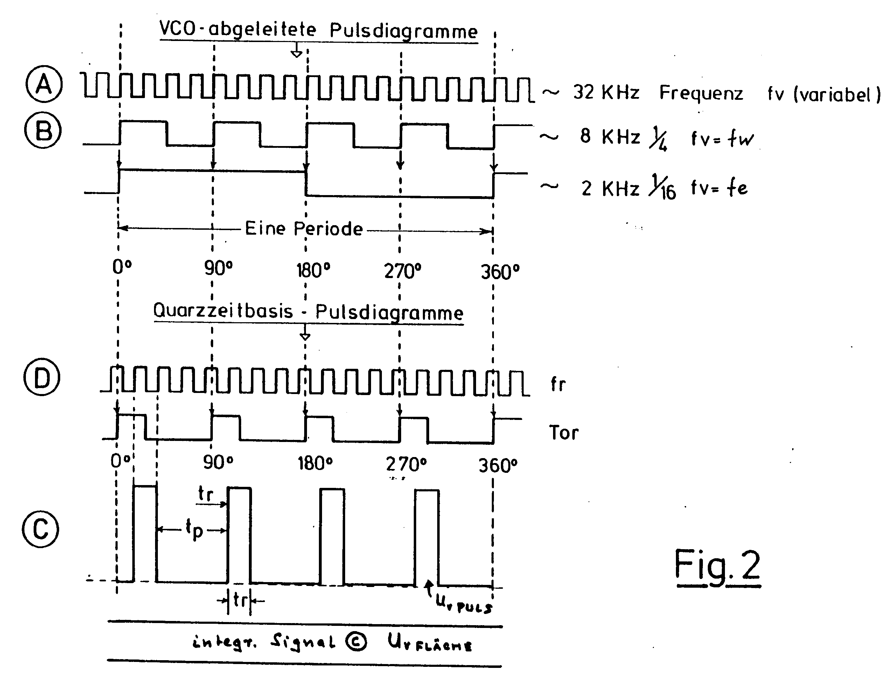

Die Funktion des Schalters 9 wird anhand der Figur 2 erläutert. Bei ansteigender Flanke des Signals "B" wird der Schalter 9 auf EINS geschaltet, d. h. ein Flip-Flop-Kreis schaltet auf einen ersten Zustand. Dieser Zustand endet, sobald vom Quarznormal 10 das Signal "D" einer Aufstiegs- und eine Abstiegsflanke eingegangen ist. Das Signal "C" wird gesetzt bei Anstiegs des Signals "D" und gleichzeitiger Stellung des Schalters 9 auf EINS. Das Signal "C" wird zurückgesetzt bei Erscheinen einer neuen Anstiegsflanke bei Signal "D". Zu diesem Zeitpunkt hat der Schalter bereits den Zustand EINS verlassen. Somit hat das Signal "C" eine Dauer von 1/fᵣ.

Die Pausenzeit tₚ ergibt sich als Zeit zwischen der Abstiegs- und der Aufstiegsflanke bei Signal "C". Entsprechend der Steuerung des sequentiellen Schalters 9 durch das Signal "B", das auf der Variablenfrequenz fᵥ beruht, sind diese Pausenzeiten nicht konstant, sondern ändern sich mit der Frequenz fᵥ. Die Frequenz fᵣ des Quarznormals 10 mit 32,728 kHz kann auch durch eine andere Referenzfrequenz ersetzt werden. Höhere Frequenzen können durch entsprechende, bekannte Teilerschaltungen entdeckt werden. Die vorliegend beschriebene Ausführungsform ergibt jedoch besonders vorteilhafte Integrationssignale.

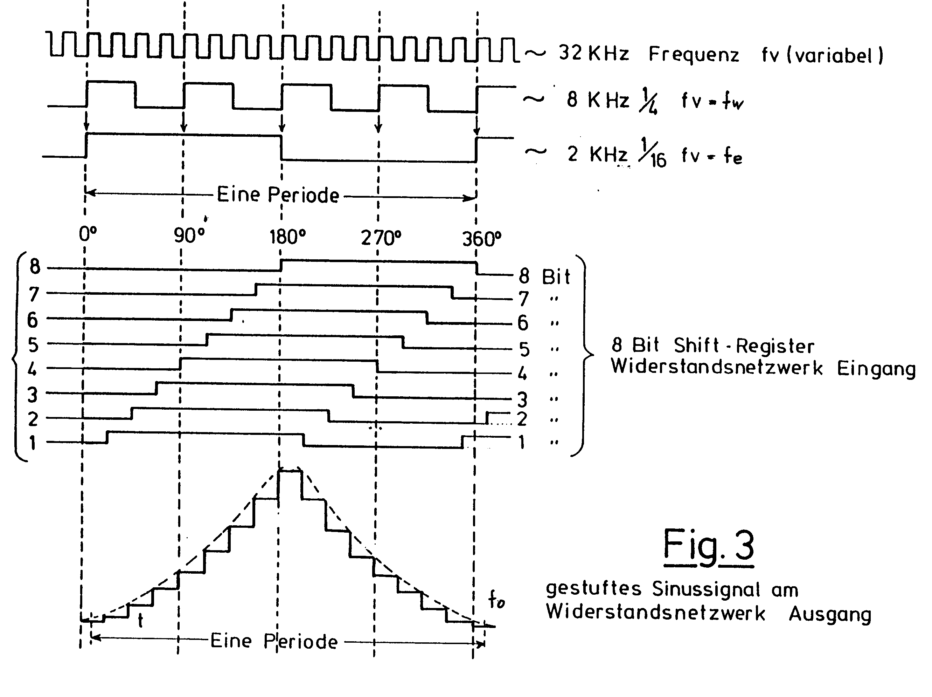

Dem 4-Bit-Teiler 7 ist ferner nachgeschaltet ein nicht mehr zur eigentlichen Oszillator-Einrichtung gehörendes 8-Bit-Schieberegister 14, das die ankommenden Signale in bestimmter Weise verschiebt und gleichzeitig einem summierenden Widerstandsnetzwerk 15 aufgibt, wobei hierbei ein gestuftes Sinussignal erzeugt wird, das durch ein Filter 16 zur Glättung geschickt wird. Anschließend ergibt sich ein Sinussignal mit einer der Meßwertspannung entsprechenden Spannung. Wie aus Figur 3 zu erkennen ist, kann die Sinusform relativ einfach erstellt werden, da eine Ausgangsfrequenz fᵥ vorliegt und diese im vorhandenen 4-Bit-Teiler 7 in einfacher Weise geteilt werden kann. Zusätzliche Teile sind keine erforderlich.

Über eine Leitung 19 wird ein 8-Bit-Schieberegister 14 getaktet, mit dem das Signal fₑ jeweils mit einem Sechzehntel der Frequenz taktweise verschoben wird. Im Widerstandsnetzwerk 17 wird eine Treppenform erzeugt, in dem die einzelnen Eingänge mit verschiedenen Widerständen entsprechend der definierten Sinuskontur geändert werden. Damit erhält man für die Sinusform immer die gleiche Amplitude bei unterschiedlichen Frequenzen, die jeweils von fᵥ abhängig ist.

Weiterhin ist eine Zeitmultiplex-Steuerung 17 vorgesehen, die ebenfalls durch das Frequenznormal 10 exakt gesteuert wird. Durch entsprechende Adressierung wird erreicht, daß jede Sensor-Einrichtung sein Signal zu einer bestimmten Zeit abgibt.

Im einzelnen wird die Funktion der in Figur 1 dargestellten adressierbaren Sensor-Transmitter-Einrichtung wie folgt erläutert, wobei zusätzlich auf die Fig. 2 und 3 Bezug genommen wird.

Der spannungsgesteuerte Oszillator 6 erzeugt in Abhängigkeit von der Spannung Uᵥ vom Integrator 5 ein Rechteck-Ausgangssignal der Frequenz fᵥ im Bereich zwischen 11,2 bis 33,6 kHz. Diese Werte haben sich als günstig erwiesen, da im allgemeinen preiswerte Uhren-Frequenznormale der Frequenz 32,728 kHz zur Verfügung stehen. Die Ausgangsfrequenz fᵥ ist üblicherweise nicht exakt proportional der angelegten Spannung, wenn nicht gemäß dem im folgenden beschriebenen Verfahren gearbeitet wird. Mit dem vorliegenden Verfahren wird angestrebt, die lineare Änderung der Ausgangsfrequenz fᵥ exakt der angelegten Meßspannung Uᵥ folgen zu lassen.

Ziffer 1 der Figur 2 zeigt die Ausgangsfrequenz fᵥ des Oszillators 6. Mit Hilfe des 4-Bit-Teilers 7 wird die Frequenz fᵥ soweit heruntergeteilt, daß sie nur noch 1/16 der gewünschten Ausgangsfrequenz hat, d. h. im Bereich von etwa 0,7 bis 2,1 kHz liegt. Hierbei wird eine Folge von Rechteck-Signalimpulsen abgegeben. Diese Frequenz entspricht der Ausgangsfrequenz der Gesamtsensorschaltung.

Zum Aufbau eines geschlossenen Regelkreises, der zur Stabilisierung des Ausgangssignales erforderlich ist, wird parallel zur Spannung Uᵥ am Eingang des Integrators 5 eine Referenzspannung Uᵣ benötigt, die am Ausgang des Tiefpaßfilters 12 zur Verfügung steht. Gewonnen wird diese Spannung aus einer Folge von Rechteckimpulsen, die von einer quarzgesteuerten Schaltung 10 im Torschalter 9 dem Tiefpaßfilter 12 zugeführt werden.

Die Frequenz fᵥ wird in 90°-Schritte zerlegt, d. h. jeweils bei 0°, 90°, 180°, 270 und wiederum bei 360° wird eine Schaltflanke abgeleitet, die über den Torschalter 9 eine Signalfolge C ergibt, deren Rechteckimpulse eine Zeitdauer tᵣ = 1/fᵣ hat. Pro Periode des Sensorausgangs fₑ werden jeweils vier konstante Impulse nach etwa 90° der genannten Zeitdauer tᵣ durchgeschaltet. Ihre Länge ist quarzstabil und vollkommen unabhängig von der Frequenz fᵥ. Allerdings ist die Summe der Pausenzeit tₚ zwischen Ende und Beginn der Rechteckimpulse des Torschalters 9 plus der jeweiligen Zeiten tᵣ umgekehrt proportional zu der Frequenz am Ausgang des Oszillators 6 oder der Ausgangsfrequenz fₑ. Mit anderen Worten: Mit steigender Frequenz fᵥ rückt die Signalfolge C enger zusammen, mit fallender Frequenz fᵥ rückt sie weiter auseinander. In mathematischen Zusammenhängen ausgedrückt gilt:${\text{U}}_{\text{r}} \text{Fläche =} \frac{{\text{t}}_{\text{r}}}{{\text{t}}_{\text{r}} {\text{+ t}}_{\text{p}}} {\text{. U}}_{\text{r}} \text{Puls}$
wie in einfacher Weise aus der Figur 2 abgelesen werden kann. Uᵣ Fläche ändert sich absolut proportional mit der Oszillatorfrequenz fᵥ. Damit ändert sich das Flächenintegral gemäß Figur 2 absolut linear mit der Frequenz fᵥ.

Die Signalfolge C kann beispielsweise über den Tiefpaß 12 geschickt werden und damit integriert werden, wobei ihre Gesamtfläche summiert wird. Die sich ergebende Integrationsspannung Uᵣ ist eine quarzgesteuerte Referenzspannung, deren Änderung absolut linear mit der Frequenz fᵥ erfolgt.

Der differenzbildende Integrator 5 bekommt nun sowohl die ursprüngliche Meßspannung Uᵥ als auch die Referenzspannung Uᵣ zugeführt. Gemäß Schaltung des Integrators 5 werden diese Spannungen voneinander subtrahiert. Ist die Meßsignalspannung Uᵥ größer als die Referenzspannung Uᵣ, so läuft die Integratorausgangsspannung langsam aufwärts. Ist die Meßsignalspannung Uᵥ kleiner als die Referenzspannung Uᵣ, so läuft die Integratorspannung abwärts.

Am Ausgang des Integrators 5 steht demnach eine Regelspannung U_{d} zur Verfügung, die den spannungsgesteuerten Oszillator 6 steuert. Die Regelspannung steuert den Oszillator jetzt solange aufwärts bzw. abwärts, bis die Referenzspannung am Eingang des Integrators absolut gleich der Meßeingangsspannung Uᵣ ist. Ist der Gleichstand erreicht, so wird der Integrator weder positiv noch negativ gesteuert, d. h. seine Regelausgangsspannung ist konstant. Seine Frequenz ändert sich nicht mehr.

Sollte der spannungsgesteuerte Oszillator 6, beispielsweise durch Temperatureinfluß, seine Ausgangsfrequenz trotz konstanter Regelspannung Uᵥ ändern, so ändert sich auch die integrierte Spannung Uᵣ. Der Integrator 5 erzeugt damit eine geänderte Eingangsspannung Uᵥ, die den spannungsgesteuerten Oszillator entgegen der unerwünschten Auswanderung zurückregelt, bis er den exakten Wert der Meßspannung erreicht hat. Damit ist ein geschlossener Regelkreis geschaffen, bei dem die Ausgangsspannung des Oszillators nicht mehr von dessen Stabilität abhängig ist, sondern nur noch von der Genauigkeit des Frequenznormals 10.

Die präzise gesteuerte Ausgangsfrequenz fᵥ, die über den 4-Bit-Teiler 7 geschickt worden ist, kann über ein digital erzeugtes gestuftes Sinussignal in ein Sinussignal gleicher Frequenz umgewandelt werden. Die Wandlung erfolgt in dem 8-Bit-Schieberegister 14 mit einem nachgeschalteten Widerstands-Netzwerk (vgl. Fig. 2). Das Widerstandsnetzwerk 15 ist so abgestuft, daß die zusammengeschalteten Signale bei Ansteuerung durch das Schieberegister ein treppenförmiges Sinussignal (vgl. Fig. 2) erzeugen. Dieses Signal wird durch das Filter 16 geschickt, an dessen Ausgang ein reines Sinussignal zur Verfügung steht. Dieses reine Sinussignal steht damit als eingeprägte Spannung zur Verfügung. In einem nachfolgenden Spannungs-Strom-Wandler wird ein sinusförmig verlaufendes Signal mit eingeprägtem Strom gewandelt (Bezugszahl 18).

Die Ansteuerung und Signalabrufung wird über eine bekannte Zeit-Multiplex-Steuerung 17 vorgenommen. Es ist darauf hinzuweisen, daß der Stromverbrauch konstant ist, so daß nur der sinusförmig verlaufende Strom des U/I-Wandlers als Modulationswechselstrom dem übrigen Gleichstrom überlagert ist. Dieser eingeprägte Modulationsstrom kann am entfernten Empfängereingang als Übertragungsnutzsignal ausgewertet werden.

Die Zeit-Multiplex-Steuerung sorgt für eine Ablaufsteuerung, wobei sich aufgrund der Steuerung jeweils ein Zeitfenster von jeweils 2 s ergibt, wobei in diesem Zeitfenster für 1,5 s die Modulation des entsprechenden Sensors (700 Hz bis 2100 Hz) eingeschaltet ist.

Die Erfindung wird insbesondere angewandt auf Sensor-Schaltungen. Sie bezieht sich daher insbesondere auch auf eine Sensorschalteinrichtung, die von der vorgenannten U/F-Wandlung mittels spannungsgesteuertem Oszillator (VCO) Gebrauch macht.

## Patentansprüche

1. Verfahren zur Stabilisierung der Ausgangsfrequenz fᵥ eines spannungsgesteuerten Oszillators, an dessen Eingang eine Spannung Uᵥ anliegt und bei dem das Ausgangssignal proportional und linear mit der Eingangsspannung Uᵥ mit der Frequenz fᵥ in Form von Rechteck-Impulsen abgegeben wird,
mit folgenden Verfahrensschritten:
- Erzeugen eines konstant-frequenten Referenzsignales mit der Frequenz fᵣ, das die gleiche Größenordnung hat, wie die Frequenz des Ausgangssignals, d. h. es sei${\text{f}}_{\text{v}} {\text{≈ f}}_{\text{r}}$
- Teilen der Ausgangsfrequenz fᵥ mit dem Faktor n und Erzeugen einer weiteren Rechtecksignalfolge B mit der Frequenz f_{w} = fᵥ/n,
- Aufschalten der Signalfolge B auf einen Torschalter zusammen mit dem Referenzsignal und Erzeugen einer Signalfolge C, deren Rechteckimpulse eine Zeitdauer tᵣ = 1/fᵣ haben und bei dem die Pausenzeit tₚ ist, wobei der Zusammenhang gilt, daß im Mittel${\text{t}}_{\text{r}} {\text{+ t}}_{\text{p}} \text{=} \frac{\text{1}}{{\text{f}}_{\text{w}}}$ ist,
gekennzeichnet durch Integration der Signalfolge C zum Erzeugen einer Regelspannung Uᵣ und Vergleich der Regelspannung Uᵣ mit der Spannung Uᵥ zur Gewinnung einer Steuerspannung U_{d} zur Steuerung des spannungsgesteuerten Oszillators (VCO).

2. Verfahren nach Anspruch 1, dadurch gekennzeichnet, daß die Referenzfrequenz quarzgesteuert ist, wobei fᵣ = 32,728 kHz beträgt.

3. Verfahren nach Anspruch 1 und 2, dadurch gekennzeichnet, daß die Ausgangsfrequenz fᵥ zwischen 11 und 34 kHz regelbar ist.

4. Verfahren nach Anspruch 1, dadurch gekennzeichnet, daß die Regelspannung Uᵣ und die Eingangsspannung Uᵥ einem Differenz-Integrator eingegeben werden, der die Differenz Δ U = Uᵥ - Uᵣ integriert und als Steuerspannung 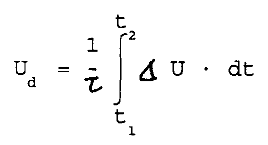 dem spannungsgesteuerten Oszillator eingibt (τ: Zeitkonstante; t₁, t₂ Meßgrenzen).

5. Verfahren nach Anspruch 1, dadurch gekennzeichnet, daß der Teilungsfaktor n = 4 ist.

6. Verfahren nach Anspruch 1, dadurch gekennzeichnet, daß die Signalfolge mit der Frequenz fᵥ über einen weiteren Wandler in ein gestuftes Sinussignal der Frequenz 1/16 fᵥ = fₑ umgesetzt wird, das über eine Filteranordnung zu einem reinen Sinussignal geglättet wird.

7. Spannungsgesteuerte Oszillatoreinrichtung (VCO) zum Durchführen des Verfahrens nach Anspruch 1, dadurch gekennzeichnet, daß zum Stabilisieren der Ausgangsfrequenz fᵥ des spannungsgesteuerten Oszillators (6) an dessen Eingang eine von der Spannung (Uᵥ - Uᵣ) abgeleitete Spannung anliegt, ein Frequenznormal (10) als Frequenzgeber mit der Referenzfrequenz fᵣ vorgegeben ist, dessen Ausgangssignal einem Torschalter (9) zusammen mit einem Signal B aufgegeben wird, dessen Freqenz f_{w} in einem festen Verhältnis 1/n zur Ausgangsfrequenz fᵥ steht und das mit Hilfe des Torschalters (9) eine Rechteck-Signalfolge C erzeugbar ist, die von der Differenz der Referenzfrequenz fᵣ und der Frequenz f_{w} abhängt und deren konstante Rechteckimpulse die Zeitlänge tᵣ = 1/fᵣ aufweisen, deren Pausenzeiten${\text{t}}_{\text{p}} \text{=} \frac{\text{1}}{{\text{f}}_{\text{w}}} \text{-} \frac{\text{1}}{{\text{f}}_{\text{r}}}$ sind und daß dem Eingang des spannungsgesteuerten Oszillators (6) ein Differenz-Integrator (5) mit Differenzeingängen zum Erzeugen eines Signals 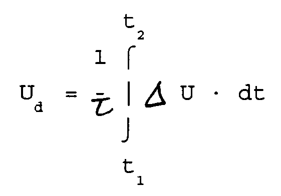 vorgeschaltet ist, wobei U_{d} eine Regelspannung für den spannungsgesteuerten Oszillator ist.

8. Oszillatoreinrichtung (VCO) nach Anspruch 7, dadurch gekennzeichnet, daß der Ausgang des Oszillators mit einem 4-Bit-Teiler (7) und dieser mit einem 8-Bit-Schieberegister (14) verbunden sind, dem ein Widerstandsnetzwerk (15) nachgeschaltet ist, so daß mit vorgenannten Elementen (7, 14, 15) eine gestufte Sinuskurve der Periode 1/16fᵥ erzeugbar ist.

9. Sensoreinrichtung, dadurch gekennzeichnet, daß zum Übertragen und Wandeln des Sensor-Spannungssignals eine Osziallatoreinrichtung gemäß den Ansprüchen 7 und 8 verwendet wird.

## Claims

1. A method of stabilising the output frequency fᵥ of a voltage-controlled oscillator at whose input a voltage Uᵥ is applied and in which the output signal is delivered in proportion and in linear manner with the input voltage Uᵥ at the frequency fᵥ in the form of square-wave pulses, the method comprising the following steps:
- generating a constant-frequency reference signal at a frequency fᵣ of the same order as the frequency of the output signal, i.e.${\text{f}}_{\text{v}} {\text{≈ f}}_{\text{r}}$
- dividing the output frequency fᵥ by the factor n and generating an additional square-wave signal sequence B at the frequency f_{w} = fᵥ/n, and
- supplying the signal sequence B together with a reference signal to a gate circuit and generating a signal sequence C in which the square-wave pulses have a duration tᵣ = 1/fᵣ and in which the interval time is tₚ, subject on average to the following relation:${\text{t}}_{\text{r}} {\text{+ t}}_{\text{p}} \text{=} \frac{\text{1}}{{\text{f}}_{\text{w}}}$ characterised by integration of the signal sequence C to obtain a control voltage Uᵣ and comparison of the control voltage Uᵣ with the voltage Uᵥ to obtain a control voltage U_{d} for controlling the voltage-controlled oscillator (VCO).

2. A method according to claim 1, characterised in that the reference frequency is crystal-controlled, and fᵣ = 32.728 kHz.

3. A method according to claims 1 and 2, characterised in that the output frequency fᵥ is adjustable between 11 and 34 kHz.

4. A method according to claim 1, characterised in that the control voltage Uᵣ and the input voltage Uᵥ are supplied to a difference integrator which integrates the difference U = Uᵥ - Uᵣ and supplies it as a control voltage 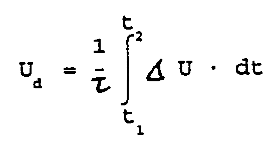 to the voltage-controlled oscillator (τ = time constant; t₁, t₂ = limits of measurement).

5. A method according to claim 1, characterised in that the division factor n = 4.

6. A method according to claim 1, characterised in that the signal sequence at the frequency fᵥ is converted by an additional converter into a stepped sine-wave signal at the frequency 1/16 fᵥ = fₑ, and smoothed by a filter arrangement to obtain a pure sinewave signal.

7. A voltage-controlled oscillator (VCO) arrangement for working the method according to claim 1, characterised in that in order to stabilise the output frequency fᵥ of the voltage-controlled oscillator (6), the input of which receives a voltage derived from the voltage (Uᵥ - Uᵣ), a frequency standard (10) in the form of a frequency transmitter at the reference frequency fᵣ is provided, and its output signal is supplied to a gate circuit (9) together with a signal B whose frequency f_{w} is in a fixed ratio 1/n to the output frequency fᵥ, and the gate circuit (9) can be used to generate a square-wave signal sequence C which depends on the difference between the reference frequency fᵣ and the frequency fᵥ and comprises constant square-wave pulses having a duration tᵣ = 1/fᵣ and intervals of lengths${\text{t}}_{\text{p}} \text{=} \frac{\text{1}}{{\text{f}}_{\text{w}}} \text{-} \frac{\text{1}}{{\text{f}}_{\text{r}}}$ and the input of the voltage-controlled oscillator (6) is preceded by a difference integrator (5) with difference inputs for generating a signal 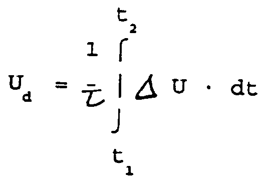 in which U_{d} is a control voltage for the voltage-controlled oscillator.

8. An oscillator arrangement (VCO) according to claim 7, characterised in that the output of the oscillator is connected to a four-bit divider (7) and the divider is connected to an 8-bit shift register (14) followed by a resistance network (15), so that the aforementioned elements (7, 14, 15) can be used to produce a stepped sine curve having the period 1/16fᵥ.

9. A sensor arrangement characterised in that an oscillator arrangement according to claims 7 and 8 is used for transmitting and converting the sensor voltage signals.

## Revendications

1. Procédé de stabilisation de la fréquence de sortie fᵥ d'un oscillateur commandé en tension, à l'entrée duquel est appliqué une tension Uᵥ et dans lequel le signal de sortie est produit de façon proportionnelle et linéaire à la tension d'entrée Uᵥ à la fréquence fᵥ sous forme d'impulsions rectangulaires,
comportant les étapes consistant à:
- engendrer un signal de référence à fréquence constante à la fréquence fᵣ, dont l'ordre de grandeur est le même que celui de la fréquence du signal de sortie, c'est-à-dire${\text{f}}_{\text{v}} {\text{≈ f}}_{\text{r}}$
- diviser la fréquence de sortie fᵥ par le facteur n et engendrer une autre séquence B de signaux rectangulaires à la fréquence f_{w} = fᵥ/n,
- appliquer la séquence de signaux B ainsi que le signal de référence à un circuit porte et engendrer une séquence de signaux C dont la durée des impulsions rectangulaires est tᵣ = 1/fᵣ et dont le temps de pause est tₚ, étant entendu que, en moyenne,${\text{t}}_{\text{r}} {\text{+ t}}_{\text{p}} \text{=} \frac{\text{1}}{{\text{f}}_{\text{w}}}$ caractérisé par une intégration de la séquence de signaux C, pour engendrer une tension de réglage Uᵣ, et une comparaison de la tension de réglage Uᵣ avec la tension Uᵥ pour obtenir une tension de commande U_{d} pour la commande de l'oscillateur commandé en tension (VCO).

2. Procédé selon la revendication 1, caractérisé en ce que la fréquence de référence est commandée par quartz, où fᵣ = 32,728 kHz.

3. Procédé selon la revendication 1 et 2, caractérisé en ce que la fréquence de sortie fᵥ est réglable entre 11 et 34 kHz.

4. Procédé selon la revendication 1, caractérisé en ce que la tension de réglage Uᵣ et la tension d'entrée Uᵥ sont amenées à un intégrateur différentiel, qui intègre la différence Δ U = Uᵥ - Uᵣ et qui applique comme tension de commande à l'oscillateur commandé en tension: 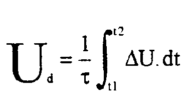 (τ = constante de temps; t₁, t₂: limites de mesure)

5. Procédé selon la revendication 1, caractérisé en ce que le facteur de division est n = 4.

6. Procédé selon la revendication 1, caractérisé en ce que la séquence de signaux à la fréquence fᵥ est transformée par un autre transformateur en un signal sinusoïdal étagé, à la fréquence 1/16 fᵥ = fₑ, qui est lissé en un signal sinusoïdal simple au moyen d'un agencement de filtre.

7. Dispositif d'oscillateur commandé en tension (VCO) pour la mise en oeuvre du procédé selon la revendication 1, caractérisé en ce que, pour stabiliser la tension de sortie fᵥ de l'oscillateur commandé en tension (6), une tension dérivée de la tension (Uᵥ - Uᵣ) est appliquée à son entrée, une fréquence étalon (10) est prédéterminée comme fréquence mère à la fréquence de référence fᵣ, dont le signal de sortie est amené avec un signal B à un circuit porte (9), dont la fréquence f_{w} présente un rapport fixe de 1/n par rapport à la fréquence de sortie fᵥ et en ce qu'il est possible d'engendrer à l'aide du circuit porte (9) une séquence C de signaux rectangulaires qui dépend de la différence entre la fréquence de référence fᵣ et la fréquence f_{w} et dont la durée des impulsions rectangulaires constantes est tᵣ = 1/fᵣ, dont les temps de pause sont$\text{tp=} \frac{\text{1}}{\text{fw}} \text{-} \frac{\text{1}}{\text{fr}}$ et en ce qu'un intégrateur différentiel (5) à entrées différentielles est monté en amont de l'entrée de l'oscillateur commandé en tension (6), pour engendrer un signal: 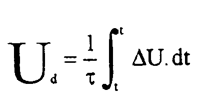 où U_{d} est une tension de réglage pour l'oscillateur commandé en tension.

8. Dispositif d'oscillateur (VCO) selon la revendication 7, caractérisé en ce que la sortie de l'oscillateur est reliée à un diviseur (7) à quatre bits et que celui-ci est relié à un registre à décalage (14) à 8 bits, en aval duquel est monté un réseau de résistances (15) de sorte qu'une courbe sinusoïdale étagée de période 1/16 fᵥ peut être engendrée à l'aide des éléments mentionnés ci-dessus (7, 14, 15).

9. Dispositif capteur, caractérisé en ce qu'un dispositif oscillateur selon les revendications 7 et 8 est utilisé pour transférer et transformer le signal de tension du capteur.
